# EUROPEAN PATENT APPLICATION

(11) **EP 3 340 747 A1**
(43) Date of publication of application: **27.06.2018**
(21) Application number: 17198485.9
(22) Date of filing: 26.10.2017
(51) Int. Cl.: H05K 1/02, H01R 13/6466, H05K 3/42, H05K 3/34, H01L 23/64, H01L 23/66, H05K 1/11

(54) **MULTI-LAYER IC SOCKET WITH AN INTEGRATED IMPEDANCE MATCHING NETWORK**

(30) Priority: 22.12.2016 US 201615388643
(71) Applicant: Google LLC, Mountain View, CA 94043 (US)
(72) Inventor: Cantin, Pierre-Luc, Mountain View, CA 94043 (US)
(74) Representative: Betten & Resch

(57) **Abstract**

At least one aspect is directed to an IC socket 400 with impedance-controlled signal lines. The IC socket includes a first plurality of signal contacts configured to make electrical connections to leads of an integrated circuit, a second plurality of signal contacts configured to make electrical connections to pads of a printed circuit board, a substrate 410 disposed between the first and second pluralities of signal contacts, and a plurality of signal lines (plated through holes 405) passing through the substrate. The substrate comprises a plurality of layers, the layers alternating between dielectric layers 440 and at least one conductor layer 420. Each signal line electrically connects a first signal contact of the first plurality of signal contacts with a second signal contact of the second plurality of signal contacts. Each conductor layer 420 defines a gap (antipad AP) around each signal line. The proximity of each signal line to each conductor layer creates a capacitance 430 between the two.

## Description

### BACKGROUND

A large integrated circuit (IC) may experience uneven thermal expansion and shrinkage relative to a printed circuit board (PCB) on which it is mounted, leading to stresses on the connections between the two that could result in failure. In addition, the IC can be difficult or impossible to repair or replace in the event of a connection failure or internal failure. The IC can therefore be mounted to an IC socket that is itself mounted to the PCB. The IC socket can buffer the differing expansion and shrinkage of the IC and PCB, and can allow for easy removal and replacement of the IC. At high frequencies, however, the signal lines of the IC socket present as an inductive spike. The mismatched impedance between the IC, the IC socket, and the PCB cause reflections and reciprocal insertion loss that can disrupt data communications.

### SUMMARY

At least one aspect is directed to an integrated circuit (IC) socket with impedance-controlled signal lines. The IC socket includes a first plurality of signal contacts configured to make electrical connections to leads of an IC, a second plurality of signal contacts configured to make electrical connections to pads of a printed circuit board (PCB), a substrate disposed between the first plurality of signal contacts and the second plurality of signal contacts, and a plurality of through hole conductors passing through the substrate. The substrate comprises a plurality of layers, the layers alternating between dielectric layers and at least one conductor layer. Each through hole conductor of the plurality of through hole conductors electrically connects a first signal contact of the first plurality of signal contacts with a second signal contact of the second plurality of signal contacts. Each conductor layer includes a conductive material defining a gap adjacent to each through hole conductor such that the conductive material is in proximity with but electrically insulated from each through hole conductor.

In some implementations, the conductive material of each conductor layer is electrically connected to a circuit ground via a low-impedance connection.

In some implementations, the conductive material is substantially contiguous throughout the at least one conductor layer except at the gap.

In some implementations, the conductive material includes a first portion and a plurality of second portions. The first portion of the conductive material is substantially contiguous throughout the at least one conductor layer. Each of the plurality of second portions of conductive material electrically connects to a through hole conductor of the plurality of through hole conductors, and the first portion of conductive material defines a gap adjacent to each of the plurality of second portions of conductive material such that the first conductive material is in proximity with but electrically insulated from each of the plurality of second portions of conductive material

In some implementations, the conductive material forms conductive traces that at least partially surround each through hole conductor.

In some implementations, each through hole conductor comprises a plated through hole defined in the substrate.

In some implementations, a characteristic impedance of at least one through hole conductor is between 40 and 50 ohms.

In some implementations, a characteristic impedance of a differential pair of through hole conductors is between 80 and 200 ohms.

In some implementations, the IC socket includes at least five conductor layers. In some implementations, the IC socket includes at least ten conductor layers.

At least one aspect is directed to system. The system includes a printed circuit board (PCB) having a plurality of pads, an integrated circuit (IC) having a plurality of leads, and an IC socket. The IC socket includes a first plurality of signal contacts electrically connected to the plurality of leads of the IC, a second plurality of signal contacts electrically connected to the plurality of pads of the PCB, a substrate disposed between the first plurality of signal contacts and the second plurality of signal contacts, and a plurality of through hole conductors passing through the substrate. The substrate includes a plurality of layers, the layers alternating between dielectric layers and at least one conductor layer. Each through hole conductor of the plurality of through hole conductors electrically connects a first signal contact of the first plurality of signal contacts with a second signal contact of the second plurality of signal contacts. Each conductor layer includes a conductive material defining a gap to each through hole conductor such that the conductive material is in proximity with but electrically insulated from each through hole conductor.

In some implementations, the conductive material of each conductor layer is electrically connected to a circuit ground via a low-impedance connection.

In some implementations, the IC socket includes a plurality of conductor layers, wherein a spacing between the conductor layers is less than one tenth of a wavelength of a signal generated by the IC and passed through a through hole conductor of the plurality of through hole conductors. In some implementations, a Nyquist frequency of the signal is greater than 10GHz. In some implementations, a Nyquist frequency of the signal is greater than 14GHz.

At least one aspect is directed to an integrated circuit (IC) socket with impedance-controlled signal lines. The IC socket includes a first plurality of signal contacts configured to make electrical connections to leads of an IC, a second plurality of signal contacts configured to make electrical connections to pads of a printed circuit board (PCB), a substrate including impedance controlling means, and a plurality of through hole conductors passing through the substrate. The substrate is disposed between the first plurality of signal contacts and the second plurality of signal contacts. Each through hole conductor of the plurality of through hole conductors electrically connects a first signal contact of the first plurality of signal contacts with a second signal contact of the second plurality of signal contacts. At least one of the through hole conductors has a characteristic impedance substantially defined by the impedance controlling means.

These and other aspects and implementations are discussed in detail below. The foregoing information and the following detailed description include illustrative examples of various aspects and implementations, and provide an overview or framework for understanding the nature and character of the claimed aspects and implementations. The drawings provide illustration and a further understanding of the various aspects and implementations, and are incorporated in and constitute a part of this specification.

### BRIEF DESCRIPTION OF THE DRAWINGS

The accompanying drawings are not intended to be drawn to scale. Like reference numbers and designations in the various drawings indicate like elements. For purposes of clarity, not every component may be labeled in every drawing. In the drawings:
Figures 1A and 1B illustrate effects of thermal expansion of an integrated circuit (IC) and printed circuit board (PCB).
Figure 2A is a diagram of a portion of an example IC socket.
Figure 2B is a diagram of an expanded perspective view of a portion of an example IC socket.
Figure 2C is a diagram of a cross sectional view of a portion of an example IC socket.
Figure 3A is a simulation model of an example IC socket without an integrated impedance matching network.
Figure 3B shows results of a simulation of the example IC socket without an integrated impedance matching network.
Figure 4 is a schematic view of an example IC socket with an integrated impedance matching network, according to an illustrative implementation.
Figure 5A is a diagram of an example conductor layer, according to an illustrative implementation.
Figure 5B is a diagram of another example conductor layer, according to an illustrative implementation.
Figure 6A is a simulation model of an example IC socket with an integrated impedance matching network, according to an illustrative implementation.
Figure 6B shows results of a simulation of the example IC socket with an integrated impedance matching network, according to an illustrative implementation.

### DETAILED DESCRIPTION

This disclosure relate generally to a multi-layer IC socket with an integrated impedance matching network. IC sockets can prevent mechanical failures in electrical connections between an integrated circuit (IC) and a printed circuit board (PCB) caused by uneven thermal expansion. IC sockets also improve serviceability of PCB subassemblies because they allow ICs to be replaced quickly by hand without soldering. As communication frequencies increase, however, the effect of impedance mismatches between the IC, the IC socket, and the PCB can cause signal reflections and insertion losses. At these high frequencies, the signal lines of the IC socket, which connect the individual leads of the IC to the PCB, present an inductive peak in the signal chain between the IC and the PCB that can disrupt the transmission of signals. This is especially true at communication frequencies above several gigahertz.

To mitigate the impedance mismatch, shunt capacitance can be added to the signal lines of the IC socket as disclosed herein. The result is a distributed inductor-capacitor ("LC") network with an impedance closer to that of the transmission lines of the IC and the PCB. The distributed LC network can be created by fabricating the substrate of the IC socket as a multi-layer stack up with alternating conductor and dielectric layers. The conductor layers can be connected to ground to form ground planes. Edges of the ground planes can be defined in proximity to the signal lines to increase the capacitance between the signal line and ground. Because the impedance of the signal line is proportional to the square root of the inductance over the shunt capacitance, increasing the shunt capacitance decreases the impedance, allowing better impedance matching with the transmission lines of the IC and the PCB. This impedance matching works for both single-ended signals and differential pairs.

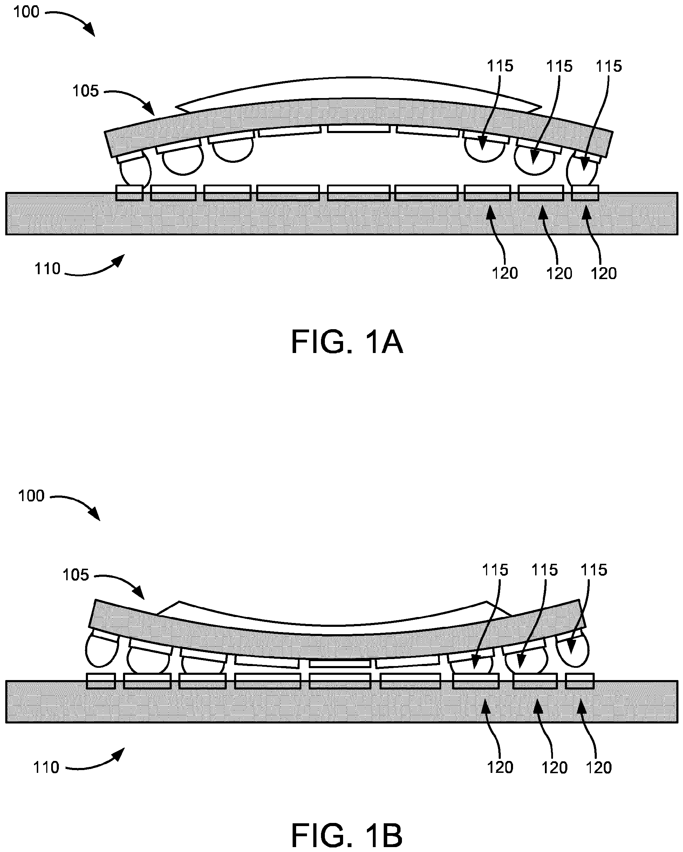

The number of layers used to create the impedance-matched signal line can depend on the transition time of the signals being transmitted, where the transition time is the length of time required for a signal to transition from high to low or vice versa. The layers can be made thin and numerous enough that the signal sees a distributed LC network and not a lump LC circuit. In this manner, the signal line can act as a transmission line with an impedance that matches the impedances of both the IC and the PCB. For example, an IC socket according to this disclosure can have signal lines consisting of copper plated through holes in a substrate including copper conductor layers interspersed between FR4 dielectric layers. A 14GHz signal traveling through this medium may have a wave propagation of 160ps/in through the plated through hole, and a 20ps transition time. The spacing between the ground planes can be set such that the transit time of the signal across a distance equal to the ground plane spacing is a fraction of the transition time. For example, the spacing between the ground planes can be set to be no more than one tenth of the wavelength of the signal through the plated through hole. Therefore, in this example the ground planes would be spaced no more than 12.5 mils apart. Figures 1A and 1B

Figures 1A and 1B illustrate effects of thermal expansion of an integrated circuit (IC) 105 and printed circuit board (PCB) 110. Large ICs, and their connections to PCBs, can suffer from stresses induced by thermal expansion. Modern computer systems, particularly those having high density layouts operating at high frequencies, generate large amounts heat. Heating of the subassemblies of the computers systems causes expansion of the PCBs and components. Depending on the materials used, the PCB 110 may have a lower coefficient of thermal expansion than the IC 105 (or vice-versa). In some situations, the two may heat unevenly. In either case, the IC 105 and the PCB 110 may expand and contract at different rates. The uneven heating and differing coefficients of thermal expansion can lead to stress in the connections between the IC 105 and the PCB 110.

For example, Figures 1A and 1B show the same IC and PCB assembly 100 in different states of relative expansion. Figure 1A shows a state in which the IC 105 has expanded more than the PCB 110. This could be due to the IC 105 having a higher coefficient of thermal expansion, or because the temperature of the IC 105 has increased more than that of the PCB 110. Figure 1A shows the solder joints between the pins 115 of the IC 105 and the pads 120 of the PCB 110 are being subjected to sheer and tensile stresses as the outer pins 115 are pulled inward and the inner pins 115 are pulled upwards by the bowing of the IC 105.

Figure 1B shows a state in which the PCB 110 has expanded more than the IC 105. This could be due to the PCB 110 having a higher coefficient of thermal expansion, or because the temperature of the has PCB 110increased more than that of the IC 105. Figure 1B shows the solder joints between the pins 115 of the IC 105 and the pads 120 of the PCB 110 are being subjected to sheer and tensile stresses as the pins 115 are pulled outward.

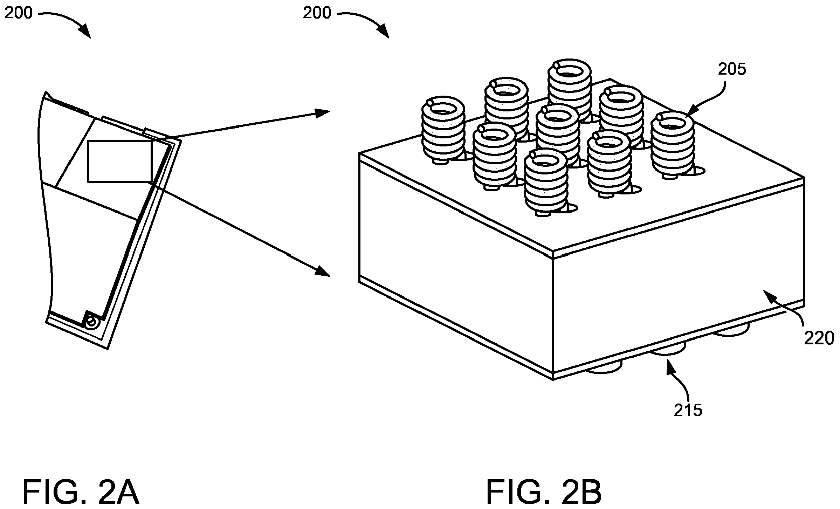

To prevent mechanical and electrical failure in these connections, designers can employ an IC socket. The IC socket can serve as a buffer between the PCB and the IC. The IC can rest on flexible contacts of the IC socket, while the IC socket is typically soldered to the PCB. This allows the IC, the IC socket, and the PCB to each expand and contract at different rates without imparting mechanical stresses on the electrical connections between each other. In addition, the IC socket can improve serviceability. If an IC fails due to uneven thermal expansion or by any other mechanism, it can be difficult or expensive to replace, especially if there are multiple large ICs on the PCB. An IC mounted in an IC socket is essentially user serviceable, however, and can be changed as easily as actuating a lever of the IC socket. Figure 2A

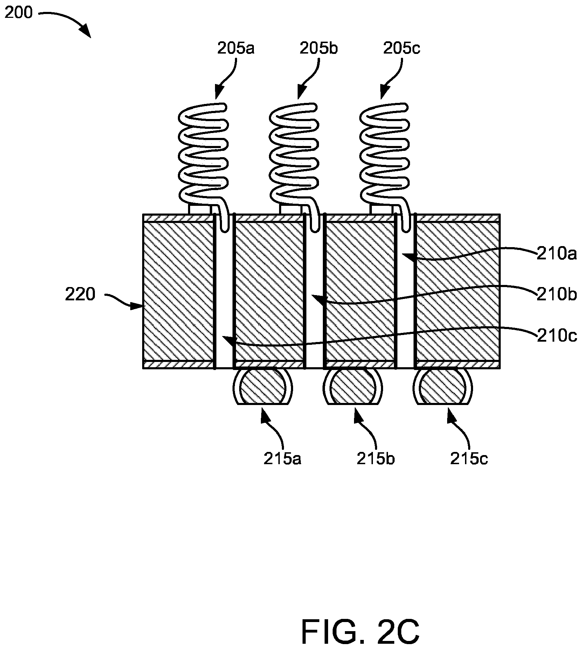

Figures 2A, 2B, and 2C are diagrams of an example integrated circuit (IC) socket 200. Figure 2A is a diagram of a portion of the IC socket 200. Figure 2B is a diagram of an expanded perspective view of a portion of the IC socket 200. Figure 2C is a diagram of a cross sectional view of a portion of the IC socket 200.

Referring to Figures 2A-2C, the IC socket 200 has a substrate 220 with a number of plated through holes (PTHs) 210 (shown in Figure 2C). At the top side of the substrate 220, the PTHs 210 are electrically coupled to a number of respective first signal contacts 205a-205c (generally first signal contacts 205). At the bottom side of the substrate 220, the PTHs 210a-210c (generally PTHs 210) are electrically coupled to a number of respective second signal contacts 215a-215c (generally second signal contacts 215). A connected first signal contact 205a, PTH 210a, and second signal contact 215a form a signal connection. The number of signal connections can be referred to as the number of positions. In general, the IC socket 200 can have a number of positions equal to the number of pins on the particular IC package the IC socket 200 is designed to receive; however, it is possible for either the IC or the IC socket to have unused positions or pins, and a perfect 1:1 match of positions to pins is not necessary.

The first signal contacts 205 are configured to mate with a pin or pad of an IC. The first signal contacts 205 can include friction contacts such as receptacles for receiving IC pins. This type of signal contact works for ICs in, for example, a dual in-line package (DIP). These types of sockets require the IC to be pushed into sprung contacts which then grip by friction. For an IC with hundreds of pins, the total insertion force can be very large (tens of newtons), leading to a danger of damage to the device or the circuit board during insertion or removal of the IC. Therefore, the signal contacts 205 can take the form of a spring contact configured to maintain an electrical connection with the IC by applying constant force on a pad of the IC while a frame or clamp holds the IC in place. Because the contact is frictionless with respect to placing the IC within the socket, this type of IC socket is referred to a "zero insertion force" socket. This type of signal contact works for ICs in a land grid array (LGA) package. Another type of zero insertion force socket includes contacts that can be actuated, by use of a lever, to close around the pins of an IC after the IC has been seated in the socket. This type of signal contact works for ICs in a pin grid array (PGA) package. The IC socket contacts can include any suitable electrically conductive material. The contacts can include a plating to resist corrosion and improve the electrical connection with the pin or pad of the IC.

The second signal contacts 215 are configured to make contact with a pad or a plated through hole of a PCB. The second signal contacts 215 can include one or more of pins, pads, or solder balls for soldering to the PCB.

The first signal contacts 205 and the second signal contacts 215 can be joined electrically by signal lines, such as the plated through holes (PTH) 210 shown in Figure 1C. The plated through hole can be formed by drilling a hole in the IC socket substrate 220, and then either electroplating the wall of the hole or fitting the hole with a rivet, tube, rod, wire, or other conductor. The conductive portion of the PTH 210 can be called a barrel. The barrel typically includes copper, but can additionally or alternatively include gold, zinc, tin, or any other suitable conductor. An annular ring of copper or other suitable conductor can be formed at either end of the hole. The annular rings, called pads, are electrically coupled to the barrel, and can connect the conductive barrel to the first signal contacts 205 and the second signal contacts 215 at either end of the plated through holes 210.

The substrate 220 provides structural support for the first signal contacts 205, the second signal contacts 215, and the plated through holes 210. The substrate 220 can include a sturdy, electrically non-conductive, machinable and/or moldable dielectric material.

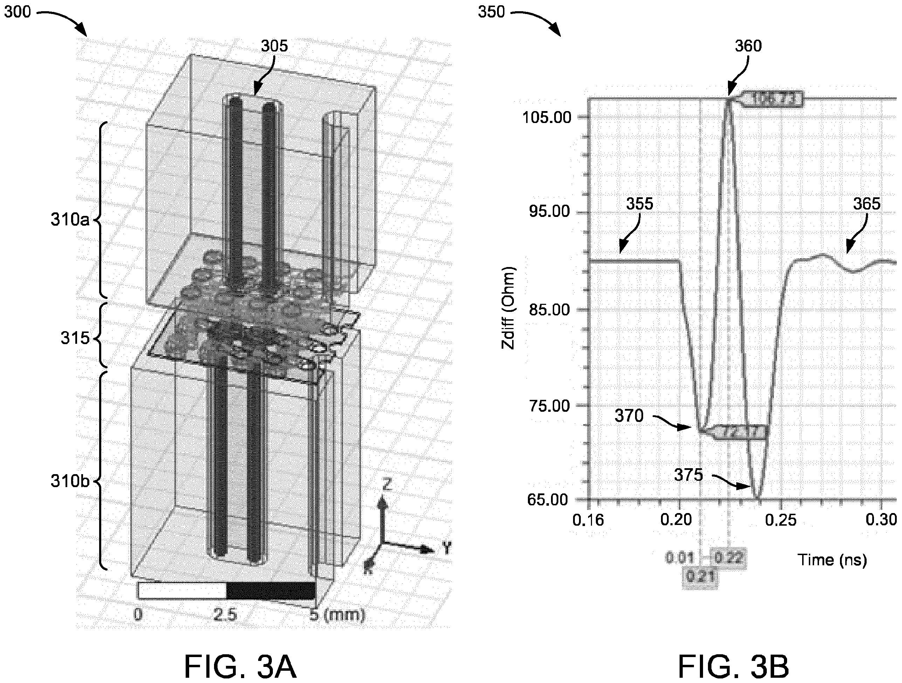

While the IC socket 200 can reduce the stresses between the IC and the PCB, the impedance of the signal lines within the IC socket can affect high-frequency signals. The impedance of the signal lines can present itself as an inductive spike to signals with frequencies in the gigahertz to tens-of-gigahertz range. This creates discontinuities between the impedance-controlled signal lines within the IC, the IC socket, and the impedance-controlled signal traces in the PCB. The discontinuity causes reflection and insertion loss of the signal, and renders the signal lines of the IC socket inoperable for signals with frequencies above a few gigahertz. The following figures illustrate this challenge. Figure 3A

Figure 3A is a simulation model 300 of an example IC socket without an integrated impedance matching network. The model 300 includes a differential signal pair 305 passing through an entrance port 310a, a device under test (DUT) 315, and an exit port 310b. The DUT 315 represents the signal lines of an IC socket without an integrated impedance matching network. The entrance port 310a and exit port 310b give the differential signal pair 305 a controlled impedance before and after the DUT 315, similar to what would be found in the signal lines of the IC and the PCB, respectively. In the simulation, a signal is injected into the differential signal pair 305 in the entrance port 310a in the direction of the DUT 315 and the exit port 310b. The simulation measures reflections of the signal back to the entrance port 310a, and reception of the signal at the exit port 310b. The results of the simulation are shown in Figure 3B.

### Figure 3B

Figure 3B shows results 350 of a simulation of the example IC socket without an integrated impedance matching network. The simulation simulates a time-domain reflectometry measurement of the model 300. Time-domain reflectometry (TDR) is a measurement technique used to determine the characteristics of signal lines by observing reflections of a step or impulse signal injected into the signal lines. A discontinuity in the signal line will cause a reflection of some or all of the injected signal. The distance to the point of the discontinuity can be determined from the delay between transmission of the injected signal and reception of the reflected signal.

The simulations results 350 show an initial flat reading 355 followed by an inductive peak 360 and a terminal flat reading 365. The simulation results 350 additionally show capacitive dips 370 and 375 on either side of the inductive peak 360. The flat readings 355 and 365 are centered at a differential impedance (Zdiff) of approximately 90 Ohms (or 45 Ohms for each signal line of the differential signal pair 305). The flat readings 355 and 365 represent transit of the signal through the entrance port 310a and the exit port 310b, respectively. The flat readings indicate that there is little, if any, reflection of the injected signal from within the entrance port 310a and the exit port 310b. As the signal traverses the DUT 315, however, it encounters discontinuities. The capacitive dip 370 represents the discontinuity between the entrance port 310a and the DUT 315. The connection between the entrance port 310a and the IC socket DUT 315 presents itself as an increase in capacitance between the differential signal pair 315, resulting in a lower apparent Zdiff. Similarly, the capacitive dip 375 represents the discontinuity between the DUT 315 and the exit port 310b. Again, the connection between the DUT 315 and the exit port 310b presents itself as an increase in capacitance between the differential signal pair 315, resulting in a lower apparent Zdiff.

The inductive peak 360 represents the discontinuity presented by the plated through holes of the IC socket. The plated through holes have a series inductance that creates a higher Zdiff. The simulation results 350 show that the inductive peak 360 has a Zdiff of 106.73 Ohms versus 90 Ohms at the flat readings 355 and 365. The inductive peak 360 causes reflections of signals traveling in the differential signal pair 305. At sufficiently high frequencies-for example, in the gigahertz and tens of gigahertz-the inductive peak 360 causes reflections of the signals severe enough to cause errors in the transmission or disrupt it completely. This can occur when the wavelength of the signal is on the order of the length of the plated through hole; for example, when the plated through hole is greater than 1/10^{th} of the wavelength of the signal. Therefore, a manner of controlling the impedance of the IC socket to reduce the inductive peak and prevent reflection of high frequency signals may improve signal transmission performance.

### Figure 4

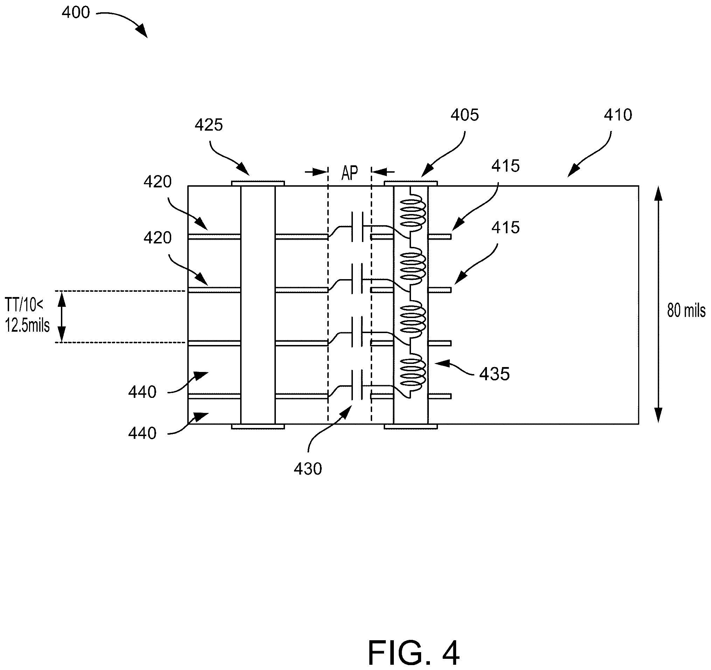

Figure 4 is a schematic view of an example IC socket 400 with an integrated impedance matching network, according to an illustrative implementation. The IC socket 400 includes a through hole conductor such as a plated through hole 405, which acts as a signal line through the substrate 410. In some implementations, the through hole conductor can include any one of the different types of conductive portions previously described. The IC socket 400 differs from the IC socket 200, however, due to the inclusion of conductor layers 420 sandwiched between layers of dielectric material 440. In some implementations, the plated through hole 405 electrically couples to an annular ring 415 in each conductor layer 420. Each annular ring 415 is separated from the rest of the conductor layer 420 by an antipad (AP), which forms a plane clearance hole or gap between the conductor layer 420 and the annular ring 415. The AP forms an insulation gap between the respective annular rings 415 and conductor layers 420, thus creating a capacitance 430. In some implementations, there is no annular ring 415, and the AP defines a gap between the conductor layer 420 and the plated through hole 405. The conductor layers 420 can be joined and connected to ground by a low impedance connection including an additional plated through hole or via 425.

Each capacitance 430 will thus be a shunt capacitance to ground. The shunt capacitance can make up for the inductive nature of the plated through hole 405 and thus better match the impedance of the IC socket 400 to the line impedance (that is, the impedance of the signal lines in the IC and on the PCB). The resulting characteristic impedance of the IC socket 400 will be based in part on the magnitude of the inductance of the plated through hole 405 and the shunt capacitances 430. For example, assuming a lossless line, the characteristic impedance of the IC socket 400 will be equal to the square root of the inductance divided by the capacitance. In some cases, the characteristic impedance can be found using per-unit-length values of inductance and capacitance. In the lossless or near lossless condition, the characteristic impedance will be purely resistive or very nearly so.

The spacing between adjacent conductor layers 420 can be set to less than 1/10^{th} of the wavelength of the highest frequency signal to be passed through the plated through hole 405. As a result, the inductances 435 and the capacitances 430 appear to the signal as a distributed LC network rather than a lumped-element network. Each capacitance 430 can be set to combine with the inductances 435 to produce a signal line of the appropriate impedance. For example, a single-ended signal line may have a characteristic impedance of 40, 45, or 50 Ohms, while a differential signal line-such as the differential signal line 305-has a characteristic impedance of 80, 90, or 100 Ohms.

An example IC chip socket 400 can be formed for signals having a Nyquist frequency of 14GHz. In an IC socket with FR4 dielectric layers 440 and copper conductor layers 420, the transition time (10-90% rise time) of the signal can be about 20 picoseconds. The velocity of wave propagation can be 160 picoseconds/inch. The transition time electrical length is equal to the transition time divided by the velocity; in this case 125 mils, where 1 mil equals 1/1,000^{th} of an inch. To keep the inter-layer distance to less than 1/10^{th} of the wavelength, the conductor layers are spaced no more than 12.5 mils apart. For an 80 mil substrate, which is enough to provide adequate physical stability, the number of conductor layers 420 is at least six.

The conductor layers 420 can include any suitable conductor such as a copper, gold, or tin. The conductor layers 420 can be formed using lamination, thin or thick film deposition, electroplating, or additive manufacturing techniques such as 3D printing.

The dielectric layers 440 can include sturdy, electrically non-conductive, machineable and/or moldable materials such as alumina, aluminum alloy, composite epoxy material (CEM), cyanate ester, diallyl phthalate (DAP), fluoropolymer (FP), FR1 epoxy glass, FR2 epoxy glass, FR4 epoxy glass, liquid crystal polymer (LCP), phenolic, plastic, polyamide (PA) nylon, glass-filled PA nylon, polybutylene terephthalate (PBT), glass-filled PBT, polyester PBT, glass-filed polycyclohexylenedimethylene terephthalate (PCT), glass-filled PCT, polyester PCT, glass-filled polyester PCT, polyester, glass-filled polyester, glass-filled polyether imide (PEI), glass-filled polyetheretherketone (PEEK), polyethersulfone (PES), glass-filled PES, polyimide, polyphenylene sulfide (PPS), glass-filled PPS, glass-filled polysulfone (PSU), polytetrafluoroethylene (PTFE), thermoplastic, glass-filled thermoplastic, polyester thermoplastic, or glass-filled polyester thermoplastic. The dielectric layer 440 material can be selected based on dielectric constant and loss factor.

The IC socket 400 can include signal contacts (not shown) for mating with the pads of the IC. The signal contacts can take the form of springs, pins, friction contacts, claws, or clamps. In the case of spring or pin contacts, a retaining frame or clamp can be used to apply opposing pressure of the IC against the contacts. In the case of claw or clamp contacts, a lever can be actuated to engage or disengage the claws or clamps against the leads of the IC. The signal contacts can include any suitable electrically conductive material including beryllium copper, beryllium nickel, brass, copper alloy, nickel boron, phosphor bronze, phosphor bronze alloy, or steel. The signal contacts can include a plating to resist corrosion and improve the electrical connection with the pin or pad of the IC. Plating materials can include bright zinc, gold, nickel, nickel boron, nickel with gold flash, silver, stainless steel, tin, or tin-lead. The IC socket 400 can employ these contacts for receiving ICs in various other package types, such as ball grid array (BGA), ceramic leadless chip carrier (CLCC), ceramic quad flat-pack (CQFP), dual in-line package (DIP), land grid array (LGA), pin grid array (PGA), plastic leaded chip carrier (PLCC), plastic quad flat package (PQFP), quad flat no leads (QFN), quad flat package (QFP), single in-line package (SIP), small outline integrated circuit (SOIC), small outline package (SOP), thin quad flat pack (TQFP), etc. The IC socket 400 can include contacts (not shown) for bonding with the pads of a PCB. The contacts can include pins, contacts, or solder balls suitable for bonding to the PCB.

The IC socket can be manufactured by a sequence of deposition, etching, and machining steps. Manufacturing can include additive manufacturing techniques including 3D printing.

### Figure 5A

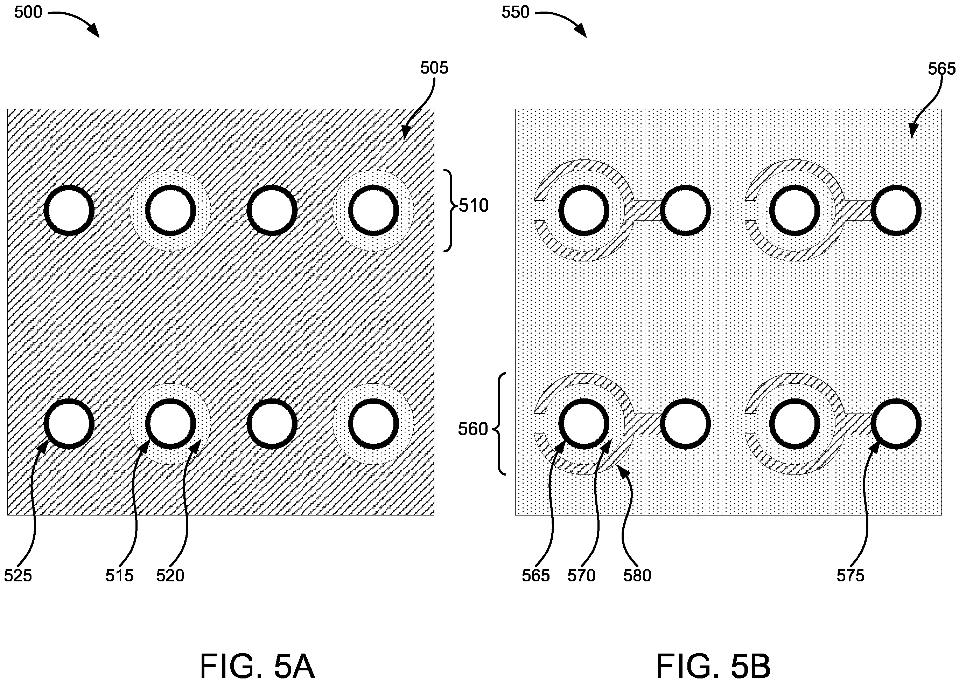

Figure 5A is a diagram of an example conductor layer 500, according to an illustrative implementation. In this example implementation, the conductor layer 500 includes a substantially contiguous plane of conductor material 505. The conductor layer 500 includes a plurality of signal lines 510 passing through it in a direction substantially perpendicular to the plane of the conductor layer 500. The conductor layer 500 also includes additional vias 525 for electrically connecting the conductor material 505 to a bias voltage or ground. The electrical connection created by the vias 525 can be a low-impedance connection to a circuit ground. Each signal line 510 includes a through hole conductor 515 surrounded by a gap 520. The gap 520 electrically insulates the through hole conductor 515 from the conductor material 505. The gap 520 therefore creates a capacitance between the through hole conductor 515 and the conductor material 505.

### Figure 5B

Figure 5B is a diagram of another example conductor layer 550, according to an illustrative implementation. In this example implementation, the conductor layer 550 includes conductor material traces 580 while including areas 565 that are free of conductor material. The areas 565 free of conductor material ultimately become electrically insulating regions. Similar to the example conductor layer 500 in Figure 5A, the conductor layer 500 includes a plurality of signal lines 560 passing through it in a direction substantially perpendicular to the plane of the conductor layer 550. The conductor layer 550 also includes additional vias 575 for electrically connecting the traces of conductor material 580 to a bias voltage or ground. The electrical connection created by the vias 575 can be a low-impedance connection to a circuit ground. Each signal line 560 includes a through hole conductor 565 surrounded by a gap 570. The gap 570 electrically insulates the through hole conductor 565 from the traces of conductor material 580. The gap 570 therefore creates a capacitance between the through hole conductor 565 and the traces of conductor material 580.

### Figure 6A

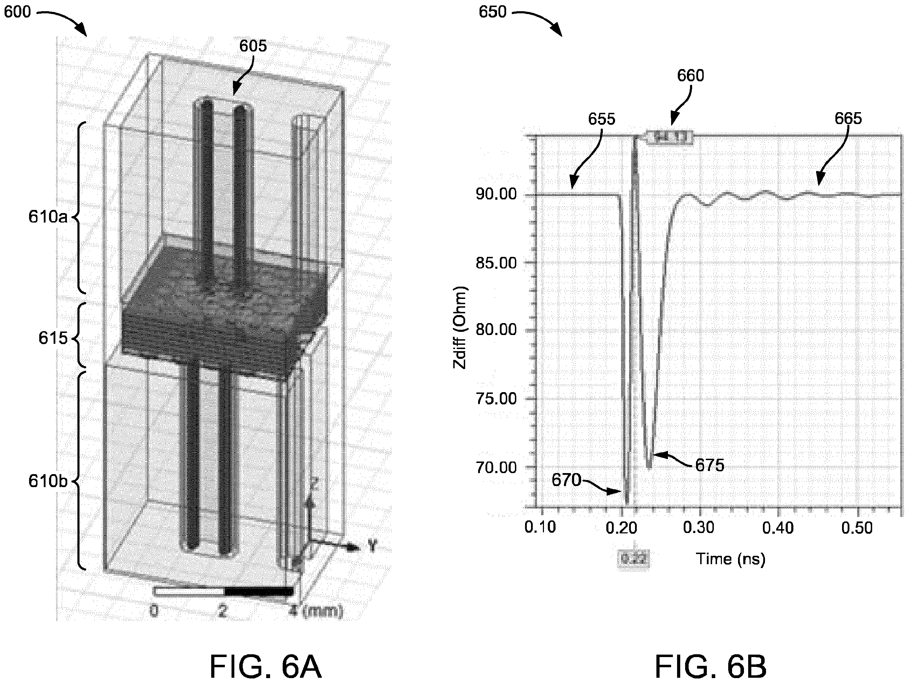

Figure 6A is a simulation model 600 of an example IC socket with an integrated impedance matching network, according to an illustrative implementation. The simulation model 600 is similar to the simulation model 300 described in Figures 3A and 3B, but with the inclusion of an impedance matching network in the device under test (DUT) 615. The simulation model 600 includes a differential signal pair 605 passing through an entrance port 610a, the DUT 615, and an exit port 610b. The DUT 615 represents the signal lines of an IC socket with an integrated impedance matching network, such as the IC socket 400 described in Figure 4. The DUT 615 in this example has seven conductor layers. The entrance port 610a and exit port 610b give the differential signal pair 605 a controlled impedance before and after the DUT 615, similar to what would be found in the signal lines of the IC and the PCB, respectively. In the simulation, a signal is injected into the differential signal pair 605 in the entrance port 610a in the direction of the DUT 615 and the exit port 610b. The simulation measures reflections of the signal back to the entrance port 610a, and reception of the signal at the exit port 610b. The results of the simulation are shown in Figure 6B.

### Figure 6B

Figure 6B shows results 650 of a simulation of the example IC socket with an integrated impedance matching network, according to an illustrative implementation. The simulation is similar to the time-domain reflectometry simulation run on the simulation model 300. The simulations results 650 show an initial flat reading 655 followed by an inductive peak 660 and a terminal flat reading 665. The simulation results 650 additionally show capacitive dips 670 and 675 on either side of the inductive peak 660. The flat readings 655 and 665 are centered at a differential impedance (Zdiff) of approximately 90 Ohms (or 45 Ohms per signal line of the differential signal pair 605). The flat readings 655 and 665 represent transit of the signal through the entrance port 610a and the exit port 610b. The flat readings indicate that there is little, if any, reflection of the injected signal from within the entrance port 610a and the exit port 610b. The signal encounters discontinuities as it traverses the DUT 615. The capacitive dip 670 represents the discontinuity between the entrance port 610a and the DUT 615. The connection between the entrance port 610a and the IC socket DUT 615 presents itself as an increase in capacitance between the differential signal pair 615, resulting in a lower apparent Zdiff. Similarly, the capacitive dip 675 represents the discontinuity between the DUT 615 and the exit port 610b. Again, the connection between the DUT 615 and the exit port 610b presents itself as an increase in capacitance between the differential signal pair 615, resulting in a lower apparent Zdiff.

The inductive peak 660 represents the discontinuity presented by the plated through holes of the IC socket. The inductive peak in this instance, however, has been mitigated by the distributed shunt capacitances 430. The simulation results 650 thus show that the Zdiff of the IC socket 400 has reduced the inductive peak 660 by 10 Ohms, from a maximum Zdiff of 106.73 Ohms in the simulation results 350 to a maximum Zdiff of 94.13 Ohms in the simulation results 660. The improved impedance matching between the IC, IC socket, and PCB will reduce the insertion loss (S21) of signals passing through the interfaces. Return loss (S11) will be reduced by a reciprocal amount. The improved impedance matching will also reduce standing waves within the plated through hole 405 caused by reflections due to the impedance mismatch at either end.

While this specification contains many specific implementation details, these should not be construed as limitations on the scope of any inventions or of what may be claimed, but rather as descriptions of features specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable sub-combination. Moreover, although features may be described above as acting in certain combinations and even initially claimed as such, one or more features from a claimed combination can in some cases be excised from the combination, and the claimed combination may be directed to a sub-combination or variation of a sub-combination.

References to "or" may be construed as inclusive so that any terms described using "or" may indicate any of a single, more than one, and all of the described terms. The labels "first," "second," "third," and so forth are not necessarily meant to indicate an ordering and are generally used merely to distinguish between like or similar items or elements.

Various modifications to the implementations described in this disclosure may be readily apparent to those skilled in the art, and the generic principles defined herein may be applied to other implementations without departing from the spirit or scope of this disclosure. Thus, the claims are not intended to be limited to the implementations shown herein, but are to be accorded the widest scope consistent with this disclosure, the principles and the novel features disclosed herein.

## Claims

1. An integrated circuit (IC) socket with impedance-controlled signal lines, comprising:
a first plurality of signal contacts configured to make electrical connections to leads of an IC;
a second plurality of signal contacts configured to make electrical connections to pads of a printed circuit board (PCB);
a substrate disposed between the first plurality of signal contacts and the second plurality of signal contacts, the substrate comprising a plurality of layers, the layers alternating between dielectric layers and at least one conductor layer; and
a plurality of through hole conductors passing through the substrate, each through hole conductor of the plurality of through hole conductors electrically connecting a first signal contact of the first plurality of signal contacts with a second signal contact of the second plurality of signal contacts, wherein each conductor layer includes a conductive material defining a gap adjacent to each through hole conductor such that the conductive material is in proximity with but electrically insulated from each through hole conductor.

2. The IC socket of claim 1,
wherein the conductive material of each conductor layer is electrically connected to a circuit ground via a low-impedance connection.

3. The IC socket of claim 1 or 2, wherein the conductive material is substantially contiguous throughout the at least one conductor layer except at the gap.

4. The IC socket of one of claims 1 to 3, wherein:
the conductive material includes a first portion and a plurality of second portions,
the first portion of the conductive material is substantially contiguous throughout the at least one conductor layer,
each of the plurality of second portions of conductive material electrically connects to a through hole conductor of the plurality of through hole conductors, and
the first portion of conductive material defines a gap adjacent to each of the plurality of second portions of conductive material such that the first conductive material is in proximity with but electrically insulated from each of the plurality of second portions of conductive material.

5. The IC socket of one of claims 1 to 4, wherein the conductive material forms conductive traces that at least partially surround each through hole conductor.

6. The IC socket of one of claims 1 to 5, wherein each through hole conductor comprises a plated through hole defined in the substrate.

7. The IC socket of one of claims 1 to 6,
wherein a characteristic impedance of at least one through hole conductor is between 40 and 50 ohms; or
wherein a characteristic impedance of a differential pair of through hole conductors is between 80 and 200 ohms.

8. The IC socket of one of claims 1 to 7, comprising at least five conductor layers; or comprising at least ten conductor layers.

9. A system comprising:
a printed circuit board (PCB) having a plurality of pads;
an integrated circuit (IC) having a plurality of leads; and
an IC socket including:
a first plurality of signal contacts electrically connected to the plurality of leads of the IC;
a second plurality of signal contacts electrically connected to the plurality of pads of the PCB;
a substrate disposed between the first plurality of signal contacts and the second plurality of signal contacts, the substrate comprising a plurality of layers, the layers alternating between dielectric layers and at least one conductor layer; and
a plurality of through hole conductors passing through the substrate, each through hole conductor of the plurality of through hole conductors electrically connecting a first signal contact of the first plurality of signal contacts with a second signal contact of the second plurality of signal contacts, wherein each conductor layer includes a conductive material defining a gap to each through hole conductor such that the conductive material is in proximity with but electrically insulated from each through hole conductor.

10. The system of claim 9, wherein the conductive material of each conductor layer is electrically connected to a circuit ground via a low-impedance connection.

11. The system of claim 9 or 10, comprising a plurality of conductor layers, wherein a spacing between the conductor layers is less than one tenth of a wavelength of a signal generated by the IC and passed through a through hole conductor of the plurality of through hole conductors.

12. The system of claim 11,
wherein a Nyquist frequency of the signal is greater than 10GHz; or
wherein a Nyquist frequency of the signal is greater than 14GHz.

13. An integrated circuit (IC) socket with impedance-controlled signal lines, comprising:
a first plurality of signal contacts configured to make electrical connections to leads of an IC;
a second plurality of signal contacts configured to make electrical connections to pads of a printed circuit board (PCB); and
a substrate including impedance controlling means, the substrate disposed between the first plurality of signal contacts and the second plurality of signal contacts; and
a plurality of through hole conductors passing through the substrate, each through hole conductor of the plurality of through hole conductors electrically connecting a first signal contact of the first plurality of signal contacts with a second signal contact of the second plurality of signal contacts, wherein at least one of the through hole conductors has a characteristic impedance substantially defined by the impedance controlling means.

14. The IC socket of claim 13,
wherein the characteristic impedance of the at least one through hole conductor is between 40 and 50 ohms; or
wherein the characteristic impedance of a differential pair of through hole conductors is between 80 and 200 ohms.

15. The IC socket of claim 13, comprising at least five conductor layers; or comprising at least ten conductor layers.
